# EUROPÄISCHE PATENTANMELDUNG

(11) **EP 1 246 365 A1**
(43) Veröffentlichungstag der Anmeldung: **02.10.2002**
(21) Anmeldenummer: 02005754.3
(22) Anmeldetag: 13.03.2002
(51) Int. Cl.: H03K 17/945

(54) **Ultraschallnäherungssensor mit Auswertung des Störabstandes**

(30) Priorität: 26.03.2001 DE 10114819
(71) Anmelder: SIEMENS AKTIENGESELLSCHAFT, 80333 München (DE)
(72) Erfinder: Luber, Ernst, 92259 Neukirchen (DE)

(57) **Zusammenfassung**

Verfahren zur Verbesserung des Signalempfangs eines Ultraschall-Näherungsschalters und Ultraschall-Näherungsschalter mit verbessertem Signalempfang

Die Erfindung betrifft ein Verfahren zur Verbesserung des Signalempfangs eines Ultraschall-Näherungsschalters (1), der ein Ultraschallsignal aussendet, das er nach Reflexion als Ultraschall-Echosignal empfängt und in ein elektrisches Signal umwandelt, das im Ultraschall-Näherungsschalter (1) weiterverarbeitet wird und proportional zur Amplitude des empfangenen Ultraschall-Echosignals ist, wobei der Störabstand zwischen einem empfangenen Ultraschall-Echosignal und vorhandenen Störsignalen der Umgebung erfasst wird. Ferner betrifft die Erfindung einen Ultraschall-Näherungsschalter zur Durchführung des Verfahrens.

## Beschreibung

Die Erfindung betrifft ein Verfahren zur Verbesserung des Signalempfangs eines Ultraschall-Näherungsschalters mit den Merkmalen des Oberbegriffs des Patentanspruchs 1. Ferner betrifft die Erfindung ein Ultraschall-Näherungsschalter mit den Merkmalen des Oberbegriffs des Patentanspruchs 9.

Aus der DE 198 48 287.6 der SIEMENS AG ist ein Verfahren zur Betriebsoptimierung eines Ultraschall-Näherungsschalters bekannt, bei der ein empfangenes Ultraschall-Echosignal amplitudenmäßig ausgewertet wird, wodurch ein Sendefrequenzabgleich und eine Ausricht-Optimierung ermöglicht werden. Falls elektrische oder akustische Umgebungsstörsignale eine bestimmte Auswerteschwelle überschreiten, können bei dem dort beschriebenen Verfahren bzw. Näherungsschalter Funktionsstörungen auftreten.

Der Erfindung liegt daher die Aufgabe zugrunde, ein Verfahren zur Verbesserung des Signalempfangs eines Ultraschall-Näherungsschalters sowie einen Ultraschall-Näherungsschalter anzubieten, bei denen auch bei vorhandenen Störsignalen ein störungsfreier Signalempfang ermöglicht wird.

Die Aufgabe wird für das Verfahren durch die Merkmale des kennzeichnenden Teils des Patentanspruchs 1 in Verbindung mit den Merkmalen des Oberbegriffs gelöst. Vorteilhafte Verfahrensvarianten werden in den Unteransprüchen 2 - 8 beschrieben. Für den Ultraschall-Näherungsschalter wird die Aufgabe durch die Merkmale des Patentanspruchs 9 in Verbindung mit den Merkmalen des Oberbegriffs gelöst. Vorteilhafte Ausführungsformen des Ultraschall-Näherungsschalters werden in den Ansprüchen 10 - 12 beschrieben.

Beim erfindungsgemäßen Verfahren wird beim Empfang von Ultraschall-Echosignalen auch der Störabstand zu vorhandenen elektrischen oder akustischen Störsignalen der Umgebung erfasst. Damit kann festgestellt werden, ob bei einem Überschreiten der Auswerteschwelle und einem Ansprechen des Ultraschall-Näherungsschalters ein zu empfangendes Ultraschall-Echosignal oder unerwünschte elektrische oder akustische Störsignale der Umgebung vorliegen, deren Amplitude die Auswerteschwelle überschreiten.

Zur Erfassung des Störabstandes wird vorteilhafterweise das elektrische Signal, in welches das empfangene Ultraschall-Echosignal gewandelt wurde, mit einem abgespeicherten elektrischen Referenzsignal verglichen. Wenn das dem empfangenen Ultraschall-Echosignal zugeordnete elektrische Signal das abgespeicherte elektrische Referenzsignal übersteigt, wurde festgestellt, dass die empfangenen Signale wesentlich durch das empfangene Ultraschall-Echosignal geprägt sind.

Gemäß einer vorteilhaften Verfahrensvariante werden in einem ersten Verfahrensschritt Störsignale der Umgebung empfangen und ausgewertet und in ein elektrisches Referenzsignal gewandelt. Hierdurch kann festgestellt werden, welche Signalcharakteristik die vorliegenden Störsignale der Umgebung aufweisen. In einem zweiten Verfahrensschritt wird ein Ultraschallsignal ausgesendet, welches nach Reflexion als Ultraschall-Echosignal wiederum in ein elektrisches Signal gewandelt und ausgewertet wird.

Gemäß einer besonders vorteilhaften Verfahrensvariante wird den empfangenen Störsignalen als elektrisches Referenzsignal eine Regelspannung eines mit einem Verstärker des Ultraschall-Wandlers verbundenen Regelverstärkers zugeordnet. Wenn nun einem empfangenen Ultraschall-Echosignal, welches in ein elektrisches Signal gewandelt wird, ebenfalls eine derartige Regelspannung zugeordnet wird, kann eine Differenz zwischen der den Störsignalen zugeordneten Regelspannung und der dem Ultraschall-Echosignal zugeordneten Regelspannung zur Erfassung des Störabstandes in der vorliegenden Störsignalsituation gebildet werden.

Wenn nach einer anfänglichen Inbetriebnahme des Ultraschall-Näherungsschalters zunächst eine Bestimmung des elektrischen Referenzsignals erfolgt, und somit die im Moment vorliegende Störsignalcharakteristik erfasst wird, können bei laufendem Betrieb des Ultraschall-Näherungsschalters die den empfangenen Ultraschall-Echosignalen zugeordneten Regelspannungen in Differenz mit dem Referenzsignal gesetzt werden, so dass bei jedem Empfang eines Ultraschall-Echosignals festgestellt werden kann, ob ein ausreichender Störabstand vorliegt. Hierbei kann der jeweils aktuell ermittelte Störabstand mit einem abgespeicherten Sollwert verglichen werden, wobei bei Unterschreitung desselben zur Verbesserung des Störabstandes eine Veränderung der Einstellung des Filters und/oder des Verstärkers des Ultraschall-Näherungsschalters durchgeführt werden können. Damit kann der Ultraschall-Näherungsschalter an eine veränderte Störsignalsituation angepasst werden, so dass ein zuverlässiger Störabstand auch unter wechselnden Störsignalbedingungen erreicht werden kann.

Der erfindungsgemäße Ultraschall-Näherungsschalter besitzt eine vom Mikroprozessor des Näherungsschalters steuerbare Messeinrichtung, die zur Erfassung von elektrischen Signalen zur Bestimmung des Störabstandes zwischen Störsignalen der Umgebung und empfangenen Ultraschall-Echosignalen dient.

Bei Verbindung der Messeinrichtung mit einem Regelverstärker des Verstärkers des Näherungsschalters, können die Regelspannungen des Regelverstärkers gemessen werden, wobei ein Vergleich zwischen der einem Störsignal zugeordneten Regelspannung und der einem empfangenen Ultraschall-Echosignal zugeordneten Regelspannung zur Erfassung und Auswertung des Störabstandes durchgeführt werden kann.

Durch den Mikroprozessor können nach einer Auswertung der Signale der Messeinrichtung falls erforderlich die Einstellungen des Verstärkers und/oder des Filters zur Verbesserung des Störabstandes aufgrund der von der Messeinrichtung ermittelten Messergebnisse verändert werden.

Die Erfindung wird im folgenden anhand einer Zeichnungsfigur näher erläutert.

Die Zeichnungsfigur zeigt den prinzipiellen schaltungsmäßigen Aufbau eines Ultraschall-Näherungsschalters 1, der einen Ultraschall-Wandler 2, eine Weiterverarbeitungseinheit 16 und einen Mikroprozessor 5 umfasst. Die Weiterverarbeitungseinheit 16 weist einen aus einem Verstärker 4, einem Filter 8, einem Demodulator 9 und einem Komparator 10 aufgebauten Zweig auf, wobei die Komponenten in der genannten Reihenfolge in Serie geschaltet sind und an einem Eingang 12 der Weiterverarbeitungseinheit 16 der Verstärker 4 und an einem Ausgang 13 derselben der Komparator 10 liegt. Über eine Regelschleife mit einem Regelverstärker 6 erfolgt eine Rückkopplung zum Verstärker 4. Der Ausgang 14 des Ultraschall-Wandlers 2 ist über den Eingang 12 der Weiterverarbeitungseinheit 16 mit dem Verstärker 4 verbunden. Der Ausgang 13 der Weiterverarbeitungseinheit 16 liegt an einem Eingang 15 des Mikroprozessors 5. Zwischen einem Ausgang 17 des Mikroprozessors 5 und dem Eingang 12 ist eine Reihenschaltung aus einem Oszillator 3 und einer Sendeendstufe 11 geschaltet.

Der Mikroprozessor 5 aktiviert über den Ausgang 17 den Oszillator 3, der abhängig von einer an seinem Eingang 20 anliegenden Steuerspannung ein Anregungssignal mit einer von der Amplitude der Steuerspannung abhängigen Oszillatorfrequenz erzeugt. Dieses Anregungssignal wird nach Verstärkung in der Sendestufe 11 an den Ultraschall-Wandler 2 weitergeleitet, der ein Ultraschallsignal mit einer der Oszillatorfrequenz entsprechenden Sendefrequenz aussendet. Nach Reflexion der Ultraschallwellen an einem Objekt empfängt der Ultraschall-Wandler 2 ein Ultraschallecho und wandelt dieses in ein elektrisches Signal um. Dieses wird in der Weiterverarbeitungseinheit 16 verstärkt, anschließend gefiltert, demoduliert und vor Übergabe an den Mikroprozessor 5 amplitudenmäßig erfasst. Das elektrische Signal wird hier nach der Filterung außerdem über den Regelverstärker 6 in der Weiterverarbeitungseinheit 16 verstärkt und die dann am Ausgang 18 des Regelverstärkers 16 anliegende Regelspannung an den Verstärker 4 rückgeführt.

Aus der Zeichnungsfigur geht ferner die erfindungsgemäße Messeinrichtung 7 hervor, über welche die jeweilige Regelspannung des Regelverstärkers 6 erfasst und zur Auswertung an den Mikroprozessor 5 weitergeleitet wird. Wenn in einem ersten Verfahrensschritt die vorhandenen Störsignale der Umgebung über den Ultraschall-Wandler 2 erfasst werden, ergibt sich am Regelverstärker 6 eine erste Regelspannung als Referenzsignal, welche von der Messeinrichtung 7 erfasst und an den Mikroprozessor 5 weitegeleitet wird.

Bei einer in einem zweiten Verfahrensschritt durchgeführten Aussendung eines Ultraschallsignals und einem nach Reflexion desselben als Ultraschall-Echosignal empfangenen Signals, liegt eine zweite Regelspannung am Regelverstärker 6 vor, die wiederum von der Messeinrichtung 7 erfasst und an den Mikroprozessor 5 weitergeleitet wird. Im Mikroprozessor 5 können nun die beiden Regelspannungen verglichen werden, wobei die dem Ultraschall-Echosignal zugeordnete Regelspannung zur Erreichung eines ausreichenden Störabstandes die dem Störsignal zugeordnete Regelspannung übersteigen soll.

Im Mikroprozessor 5 kann ein Vergleich und eine Auswertung der beiden erfassten Regelspannungen z.B. durch Differenzbildung erfolgen. Falls ein Sollwert eines nicht zu unterschreitenden Störabstandes unterschritten wird, kann ausgehend vom Mikroprozessor 5 über dessen Ausgänge 19 und 20 zum Verstärker 4 bzw. Filter 8 eine Veränderung der Einstellungen (z.B.

Verstärkungsfaktor, Filtercharakteristik) des Verstärkers 4 und/oder des Filters 8 zur Erzielung eines verbesserten Störabstandes erreicht werden. Bei zu geringem Störabstand kann z.B. die Verstärkerleistung erhöht werden.

Durch ständige Erfassung der am Regelverstärker 6 anliegenden Regelspannungen, die empfangenen Ultraschall-Echosignalen zugeordnet werden können, kann durch Vergleich eines anfänglich oder periodisch wiederholt erfassten elekrischen Referenzsignals, nämlich der einem Störsignal zugeordneten Regelspannung, ständig im Mikroprozessor 5 festgestellt werden, ob ein ausreichender Störabstand vorliegt und - falls erforderlich - die Einstellung des Verstärkers 4 und/der des Filters 8 zur Verbesserung des Störabstandes geändert werden.

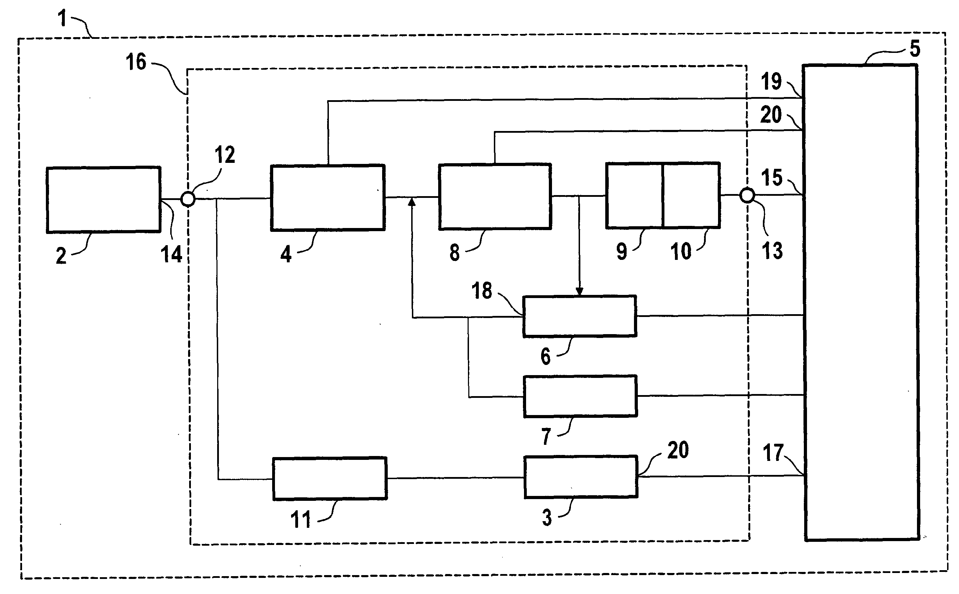

## Patentansprüche

1. Verfahren zur Verbesserung des Signalempfangs eines Ultraschall-Näherungsschalters (1), der einen Ultraschall-Wandler (2), einen Oszillator (3), einen Verstärker (4) und einen Mikroprozessor (5) umfasst, wobei der Oszillator (3) den Ultraschall-Wandler (2) mit einer Oszillatorfrequenz anregt und der Ultraschall-Wandler (2) daraufhin ein Ultraschallsignal aussendet, das er nach Reflexion als Ultraschall-Echosignal empfängt und in ein elektrisches Signal umwandelt, das im Ultraschall-Näherungsschalter (1) weiterverarbeitet wird und proportional zur Amplitude des empfangenen Ultraschall-Echosignals ist,
**dadurch gekennzeichnet, dass** der Störabstand zwischen einem empfangenen Ultraschall-Echosignal und vorhandenen Störsignalen erfasst wird.

2. Verfahren nach Anspruch 1,
**dadurch gekennzeichnet, dass** zur Erfassung des Störabstandes das elektrische Signal, in welches das empfangene Ultraschall-Echosignal gewandelt wurde, mit einem abgespeicherten elektrischen Referenzsignal verglichen wird.

3. Verfahren nach Anspruch 1 oder 2,
**dadurch gekennzeichnet, dass** zunächst Störsignale empfangen und ausgewertet werden sowie darauffolgend ein Ultraschallsignal ausgesendet und nach Reflexion als Ultraschall-Echosignal empfangen und ausgewertet wird.

4. Verfahren nach einem der vorhergehenden Ansprüche,
**dadurch gekennzeichnet, dass** den empfangenen Störsignalen als elektrisches Referenzsignal eine Regelspannung eines mit dem Verstärker (4) verbundenen Regelverstärkers (6) zugeordnet wird.

5. Verfahren nach einem der vorhergehenden Ansprüche,
**dadurch gekennzeichnet, dass** eine Differenz zwischen einer dem empfangenen Störsignal zugeordneten Regelspannung und einer einem empfangenen Ultraschall-Echosignal als gewandeltes elektrisches Signal zugeordneten Regelspannung zur Erfassung des Störabstandes gebildet wird.

6. Verfahren nach einem der vorhergehenden Ansprüche,
**dadurch gekennzeichnet, dass** der Störabstand während des Empfangs von Ultraschall-Echosignalen erfasst und ausgewertet wird.

7. Verfahren nach einem der vorhergehenden Ansprüche,
**dadurch gekennzeichnet, dass** der erfasste Störabstand mit einem abgespeicherten Sollwert verglichen wird.

8. Verfahren nach Anspruch 7,
**dadurch gekennzeichnet, dass** bei Unterschreiten des Sollwertes die Einstellungen des Filters (6) und/oder des Verstärkers (5) zur Verbesserung des Störabstandes angepasst werden.

9. Ultraschall-Näherungsschalter (1) mit einem Ultraschall-Wandler (2), einem Verstärker (4), einem Oszillator (3) durch den der Ultraschall-Wandler (2) zur Aussendung von Ultraschallewellen mit einer der Oszillatorfrequenz entsprechenden Sendefrequenz anregbar ist und mit einem Mikroprozessor (4) zur Steuerung und Auswertung der Sende- und Empfangssignale des Ultraschall-Näherungsschalters (1), insbesondere zur Durchführung eines Verfahrens zur Verbesserung des Signalempfangs gemäß einem der Ansprüche 1 - 8,
**dadurch gekennzeichnet, dass** eine vom Mikroprozessor (5) steuerbare Messeinrichtung (7) vorgesehen ist, die zur Erfassung von elektrischen Signalen zur Bestimmung des Störabstandes zwischen Störsignalen und empfangenen Ultraschall-Echosignalen dient.

10. Ultraschall-Näherungsschalter nach Anspruch 9,
**dadurch gekennzeichnet, dass** die Messeinrichtung (7) mit einem Regelverstärker (6) des Verstärkers (4) des Ultraschall-Näherungsschalters (1) verbunden ist.

11. Ultraschall-Näherungsschalter nach Anspruch 10,
**dadurch gekennzeichnet, dass** über die Messeinrichtung (7) eine Messung der Regelspannungen des Regelverstärkers (6) erfolgt.

12. Ultraschall-Näherungsschalter nach einem der Ansprüche 9 bis 11,
**dadurch gekennzeichnet, dass** der Mikroprozessor mit dem Verstärker (4) und/oder einem Filter (5) zur Anpassung der Einstellungen des Verstärkers (4) und/oder des Filters (5) zur Verbesserung des Störabstandes verbunden ist.
